# FASCICULE DE BREVET EUROPEEN

(11) **EP 3 667 728 B1**
(45) Date de publication et mention de la délivrance du brevet: **31.03.2021**
(21) Numéro de dépôt: 19213658.8
(22) Date de dépôt: 04.12.2019
(51) Int. Cl.: H01L 27/146, H01L 27/15, H01L 33/00, H01L 33/38, H01L 33/40, H01L 33/44, H01L 33/60, H01L 33/62

(54) **PROCÉDÉ DE RÉALISATION D'UN DISPOSITIF À DIODES PHOTO-ÉMETTRICES ET/OU PHOTO-RÉCEPTRICES ET AVEC UNE GRILLE DE COLLIMATION AUTO-ALIGNÉE**
VERFAHREN ZUR HERSTELLUNG EINER VORRICHTUNG MIT LICHTEMITTIERENDEN UND/ODER LICHTEMPFANGENDEN DIODEN UND MIT EINEM SELBST AUSGERICHTETEN KOLLIMATIONSGITTER
METHOD FOR MANUFACTURING A DEVICE WITH LIGHT-EMITTING AND/OR LIGHT-RECEIVING DIODES AND WITH A SELF-ALIGNED COLLIMATION GRID

(30) Priorité: 13.12.2018 FR 1872886
(43) Date de publication de la demande: 17.06.2020
(73) Titulaire: Commissariat à l'énergie atomique et aux énergies alternatives, 75015 Paris (FR)
(72) Inventeur: PARES, Gabriel, 38054 GRENOBLE CEDEX 09 (FR)
(74) Mandataire: Brevalex

(56) Documents cités:
- EP-A1- 3 024 030
- WO-A1-2014/105403
- WO-A1-2017/068029
- US-A1- 2012 007 133

## Description

### DOMAINE TECHNIQUE ET ART ANTÉRIEUR

L'invention concerne le domaine des dispositifs à diodes photo-émettrices, telles que des diodes électroluminescentes (appelées DELs ou LEDs, ou encore micro-LEDs), et/ou à diodes photo-réceptrices telles que des photodiodes. L'invention s'applique notamment au domaine suivants :
- dispositifs d'éclairage par LEDs, dispositifs électroniques comprenant des matrices de LEDs tels que des écrans, des projecteurs ou des murs d'images ;
- dispositifs électroniques ou microélectroniques photorécepteurs comportant des matrices de photodiodes, tels que des capteurs d'images ;
- dispositifs comportant à la fois des diodes photo-émettrices et des diodes photo-réceptrices, formant par exemple à la fois un capteur et un écran.

Dans les dispositifs à diodes photo-émettrices et/ou photo-réceptrices, il est avantageux d'augmenter la résolution de ces dispositifs, c'est-à-dire augmenter le nombre de cellules actives, ou pixels, par unité de surface du dispositif. Cette augmentation de la résolution implique à la fois de diminuer la taille unitaire des pixels et d'améliorer la séparation optique des pixels entre eux pour diminuer notamment le « cross talk » ou la diaphonie, c'est-à-dire les interférences optiques se produisant entre pixels adjacents. Dans le cas de pixels comprenant des diodes photo-émettrices, l'augmentation de leur directivité participe également à l'augmentation de la résolution pouvant être atteinte.

En outre, cette augmentation de la résolution doit se faire en limitant les pertes liées à la sensibilité de réception et/ou de l'émissivité des dispositifs, ce qui implique que la réduction de la surface utile ou sensible des pixels, c'est-à-dire la surface de réception et/ou d'émission des pixels, soit accompagnée d'une réduction de la surface des zones mortes périphériques, c'est-à-dire de la surface n'émettant pas ou ne recevant pas de lumière, qui correspondent par exemple aux régions occupées par les électrodes des diodes et par les régions d'isolation localisées entre et autour des pixels. Cette réduction de la surface des zones mortes périphériques implique de minimiser leur largeur autour des pixels tout en maintenant ou en améliorant la séparation optique entre les pixels.

Dans les dispositifs actuels, l'obtention de bonnes performances nécessite de réaliser un élément de séparation optique des pixels, disposé au-dessus de la face émissive et/ou réceptrice des pixels. Un tel élément de séparation optique des pixels, appelé grille de collimation ou grille de séparation, permet d'éviter les réflexions parasites entre pixels voisins et, dans le cas d'un dispositif photo-émetteur, d'améliorer la directivité d'émission lumineuse.

Généralement, la grille de collimation est rapportée au-dessus des pixels, après leur réalisation. Pour ne pas limiter la surface utile des pixels et obtenir de bonnes performances, les parois formant la grille de collimation sont réalisées aussi finement que possible, par exemple avec une largeur inférieure à environ 5 µm pour des pixels ayant chacun une surface utile dont les côtés ont une dimension (largeur) égale à environ 40 µm, et avec une hauteur importante, par exemple supérieure à environ 10 µm. De telles dimensions conduisent à ce que la grille de collimation ait un rapport de forme (rapport hauteur/largeur) important, par exemple supérieur à 2. En outre, la verticalité, la faible rugosité et une bonne réflectivité des parois permettent d'obtenir une grille de collimation qui ne perturbe pas la réflexion, la diffraction et la diffusion des signaux optiques reçus et/ou émis par les pixels.

Dans le cas d'un dispositif comprenant des diodes réalisant une photo-émission et/ou une photo-réception depuis leur face avant (face opposée à celle se trouvant du côté du substrat sur lequel les diodes sont réalisées), une telle grille de collimation peut être réalisée pendant la fabrication des niveaux d'interconnexions, également appelés BEOL (« Back-End Of Line »), du dispositif. Un de ces niveaux d'interconnexions, formés du côté de la face avant des diodes, peut être dédié à la réalisation de la grille de collimation. Cette configuration permet d'obtenir un fort degré d'intégration, et donc un faible encombrement, ainsi qu'un bon alignement de la grille de collimation avec les pixels. Toutefois, cette configuration n'est pas applicable à un dispositif réalisant une émission et/ou une réception lumineuse depuis la face arrière des diodes car les niveaux d'interconnexions sont réalisés sur la face avant du dispositif. De plus, la hauteur de la grille de collimation ainsi obtenue est limitée par les techniques mises en œuvre pour réaliser les niveaux d'interconnexions, cette hauteur étant généralement comprise entre environ 1 µm et 3 µm.

Dans le cas d'un dispositif réalisant une émission et/ou une réception lumineuse depuis sa face arrière, la grille de collimation est donc réalisée par un procédé spécifique mis en œuvre après la réalisation des niveaux d'interconnexions, le report du dispositif sur un support et le retrait du substrat à partir duquel le dispositif est réalisé. Le retrait du substrat libère la face arrière des diodes sur laquelle la grille de collimation est réalisée. Les problèmes principaux à gérer sont dans ce cas l'alignement de la grille de collimation avec les pixels, et la réalisation de la grille de collimation avec un facteur de forme important.

Lorsque la grille de collimation est reportée simultanément sur les faces arrières de plusieurs dispositifs d'émission et/ou de réception reportés sur un même support (report à l'échelle du substrat, ou « wafer level »), avant la découpe du support rendant les dispositifs unitaires, la précision d'alignement obtenue peut être inférieure à environ 1 µm. Par contre, l'alignement doit tenir compte d'une éventuelle déformation des dispositifs pouvant apparaître après avoir retiré les substrats à partir desquels les dispositifs sont réalisés. De plus, les étapes mises en œuvre pour réaliser la grille de collimation peuvent être soumises à des contraintes liées notamment à la technique utilisée pour reporter les dispositifs sur leur support, comme par exemple des contraintes de température à ne pas dépasser ou des contraintes sur les produits chimiques pouvant être utilisés sans détériorer l'interface de collage entre les dispositifs et le support.

Lorsque la grille de collimation est réalisée sur un dispositif d'émission et/ou de réception lumineuse unitaire, par exemple de taille millimétrique, reporté sur un support correspondant par exemple à un circuit actif de type ASIC (« Application-Specific Integrated Circuit », ou circuit intégré propre à une application) au moyen de connexions électriques de type, par exemple, micro-pilier ou micro-bille, il est difficile d'obtenir un bon alignement entre la grille de collimation et les pixels car les techniques de la microélectronique ne sont plus utilisables pour la réalisation de la grille de collimation. Il est également difficile de réaliser la grille de collimation avec un facteur de forme important compte tenu des procédés applicables à cette échelle et de la topologie du dispositif. Par ailleurs, la grille de collimation ne peut pas être réalisée sur le dispositif avant son report sur le support car d'une part il est nécessaire de solidariser le dispositif au support avant de retirer le substrat pour garder une bonne stabilité mécanique de l'ensemble, et d'autre part la topologie créée par la grille de collimation rendrait très difficile le report du dispositif sur son support.

Pour réaliser une grille de collimation sur un dispositif d'émission et/ou de réception lumineuse unitaire, il est possible de reconstituer une plaque à partir des dispositifs reportés au préalable sur leurs supports (par exemple des diodes chacune assemblée sur une puce CMOS), afin de permettre l'utilisation de techniques de la microélectronique capables d'atteindre les performances en alignement et la résolution nécessaires à la réalisation de la grille de collimation. Un tel procédé implique de solidariser les dispositifs et leurs supports sur une plaque, puis de réaliser une surface plane en les noyant dans un matériau d'encapsulation sans endommager les dispositifs. La grille de collimation est ensuite réalisée par lithographie sur les faces arrières des dispositifs. Dans ce cas, il est toutefois nécessaire de prendre en compte le désalignement des dispositifs lié à leur report individuel sur la plaque et au procédé de reconstruction, ce désalignement pouvant être au final de plusieurs microns. En outre, une grille de collimation ayant une hauteur de plusieurs microns et un facteur de forme supérieur à 2 requiert un procédé de lithographie compliqué nécessitant des équipements très sophistiqués.

Le document WO 2017/068029 A1 divulgue un dispositif à diodes photo-émettrices ou photo-réceptrices, ainsi qu'un procédé de fabrication correspondant, qui permet de réduire à la fois: pertes de surface active et pertes optiques latérales. Le procédé connu de WO 2017/068029 A1 n'aboutit toutefois pas à former une grille, ni un collimateur, en saillie du dispositif final.

### EXPOSÉ DE L'INVENTION

Un but de la présente invention est de proposer une solution pour séparer optiquement les pixels adjacents d'un dispositif photo-émetteur et/ou photorécepteur en face arrière tout en en minimisant la surface occupée sur le dispositif pour y parvenir, offrant un bon alignement entre les pixels et la grille de collimation utilisée pour réaliser cette séparation optique, qui soit compatible avec la réalisation d'une grille de collimation ayant un rapport de forme important, par exemple supérieur ou égal à 2, et qui puisse s'appliquer à des dispositifs unitaires ou à plusieurs dispositifs disposés sur un même support.

Pour cela, la présente invention propose un procédé de réalisation d'au moins un dispositif à diodes photo-émettrices et/ou photo-réceptrices, comportant au moins :
- réalisation, sur un substrat, d'un empilement de couches comprenant au moins des première et deuxième couches de semi-conducteurs dopés selon des types de conductivité opposés, la première couche étant disposée entre le substrat et la deuxième couche ;
- première gravure de l'empilement depuis une face avant de l'empilement se trouvant du côté opposé à celui disposé contre le substrat, formant des premières ouvertures traversant toute l'épaisseur de la deuxième couche et dont des parois de fond sont formées par la première couche ;
- réalisation de portions diélectriques recouvrant, dans les premières ouvertures, des flancs latéraux formés au moins par la deuxième couche ;
- deuxième gravure de l'empilement, prolongeant les premières ouvertures à travers une épaisseur restante de la première couche jusqu'à atteindre le substrat, les premières ouvertures délimitant des portions des première et deuxième couches formant des jonctions p-n des diodes ;
- gravure supplémentaire prolongeant les premières ouvertures dans une partie du substrat ;
- réalisation de premières portions électriquement conductrices disposées dans les premières ouvertures et en contact électriquement avec des flancs latéraux des portions de la première couche, formant des premières électrodes des diodes, et réalisation de deuxièmes électrodes reliées électriquement aux portions de la deuxième couche ;
- suppression du substrat, révélant une face arrière de l'empilement de couches formant une face émissive de chacune des diodes et libérant des parties des premières portions électriquement conductrices formant une grille de collimation.

Avec ce procédé, la grille de collimation et les premières électrodes des diodes sont formées par les mêmes éléments (les premières portions électriquement conductrices), en utilisant, pour leur réalisation, le substrat à partir duquel les diodes sont réalisées. Ainsi, la grille de collimation est auto-alignée avec les premières électrodes des diodes, ce qui limite les pertes optiques au sein du dispositif et supprime les problèmes d'alignement de la grille de collimation vis-à-vis des diodes rencontrés dans les procédés de l'art antérieur. Cela permet en outre de réduire les dimensions des zones mortes au sein du dispositif puisqu'aucune surface n'est perdue à cause d'un désalignement entre la grille de collimation et les pixels.

Dans ce procédé, les éléments formant la grille de collimation sont réalisés avant la suppression du substrat, ce qui évite les problèmes liés à une éventuelle déformation des diodes pouvant apparaître après avoir retiré le substrat, et supprime les contraintes liées à la technique utilisée pour reporter les dispositifs sur leur support étant donné que les éléments de la grille de collimation sont réalisés avant la suppression du substrat.

Ce procédé a également pour avantage de permettre la réalisation de la grille de collimation avec une géométrie très favorable pour obtenir de bonnes performances d'isolation optique entre les pixels et de faibles réflexions parasites entre les pixels. La grille de collimation peut notamment être réalisée telle que les parties des premières portions électriquement conductrices formant cette grille présentent un facteur de forme par exemple supérieur à 2, ou avantageusement supérieur ou égal 4.

Ce procédé offre également une grande liberté concernant la géométrie avec laquelle les éléments de la grille de collimation sont réalisés, du fait que la forme des parties des premières portions électriquement conductrices formant la grille de collimation est définie par la forme des premières ouvertures réalisées dans le substrat qui peut être aisément adaptée en fonction des besoins.

Ce procédé a également pour avantage de pouvoir être mis en œuvre à l'échelle du substrat par des techniques de la micro-électronique avec une grande précision, une grande robustesse et une grande reproductibilité, mais également pour des dispositifs unitaires.

Ce procédé combine avantageusement la réalisation de la grille de collimation avec une réalisation des électrodes des diodes performante et contribuant à l'optimisation de la surface utile des diodes.

En outre, la grille de collimation ainsi réalisée ne présente pas de discontinuité avec les premières électrodes des diodes, ce qui conduit à une meilleure tenue mécanique de la grille de collimation sur les diodes, un cross-talk plus faible, et une réduction des réflexions parasites au sein du dispositif.

La réalisation simultanée de la grille de collimation et des premières électrodes des diodes permet également de réduire le nombre total d'étapes à mettre en œuvre pour réaliser la grille de collimation et les premières électrodes des diodes.

Ce procédé s'applique à la réalisation d'un dispositif dont les diodes réalisent une photo-émission et/ou une photo-réception depuis une face arrière de l'empilement de couches (face se trouvant du côté du substrat sur lequel l'empilement de couches est disposé). Les diodes peuvent être interconnectées électriquement au niveau de leurs faces avants.

Lorsque du semi-conducteur non intentionnellement dopé est présent entre les première et deuxième couches, les jonctions des diodes correspondent à des jonctions p-i-n.

La partie du substrat dans laquelle la gravure supplémentaire prolongeant les premières ouvertures est mise en œuvre peut avoir une épaisseur comprise entre 1 µm et 20 µm. Cette profondeur correspond à la hauteur de la grille de collimation obtenue. La hauteur finale de la grille de collimation du dispositif peut toutefois être différente de cette profondeur si par exemple des portions de matériau électriquement conducteur supplémentaires sont formées sur les premières portions électriquement conductrices, par exemple après avoir supprimé le substrat, pour augmenter la hauteur de la grille de collimation. De manière avantageuse, la partie du substrat dans laquelle la gravure supplémentaire prolongeant les premières ouvertures est mise en œuvre peut avoir une épaisseur supérieure à 3 µm afin d'obtenir une grille de collimation de hauteur supérieure à 3 µm.

Un rapport entre l'épaisseur de la partie du substrat dans laquelle la gravure supplémentaire prolongeant les premières ouvertures est mise en œuvre et une plus petite dimension de chaque première ouverture dans un plan parallèle à une interface entre le substrat et l'empilement de couches (cette plus petite dimension correspondant à la largeur des parties des premières portions électriquement conductrices formant la grille de collimation), correspondant au rapport de forme de parties des premières portions électriquement conductrices formant la grille de collimation, peut être supérieur ou égal à 2, voire avantageusement supérieur ou égal à 4.

La première gravure de l'empilement peut être mise en œuvre telle que les premières ouvertures traversent également une partie de la première couche, et les portions diélectriques peuvent être réalisées telles qu'elles recouvrent, dans les premières ouvertures, des flancs latéraux de ladite partie de la première couche. Cette configuration permet de former une bonne isolation électrique entre les premières électrodes et la deuxième couche de semi-conducteur.

Le procédé peut être tel que :
- l'empilement comporte un masque diélectrique formant la face avant de l'empilement,
- les première et deuxième gravures de l'empilement sont mises en œuvre à travers le masque diélectrique telles que les premières ouvertures traversent également le masque diélectrique, et
- les portions diélectriques recouvrent également, dans les premières ouvertures, des flancs latéraux du masque diélectrique.

Ce masque diélectrique contribue également à la réalisation d'une bonne isolation électrique entre les premières et deuxièmes électrodes au niveau des faces avants des diodes.

La deuxième gravure de l'empilement peut être réalisée telle que des flancs latéraux des portions diélectriques sont alignés avec les flancs latéraux des portions de la première couche.

Le procédé peut comporter en outre, entre la deuxième gravure de l'empilement et la réalisation des premières portions électriquement conductrices, la réalisation de deuxièmes ouvertures traversant le masque diélectrique et dans lesquelles les deuxièmes électrodes peuvent être au moins partiellement réalisées.

Les premières et deuxièmes électrodes peuvent être réalisées en déposant au moins un matériau électriquement conducteur dans les premières et deuxièmes ouvertures et sur le masque diélectrique, puis en mettant en œuvre une étape de planarisation du matériau électriquement conducteur avec arrêt sur le masque diélectrique.

L'empilement peut comporter en outre une couche électriquement conductrice telle que la deuxième couche soit disposée entre la couche électriquement conductrice et la première couche, et la première gravure de l'empilement peut être mise en œuvre telle que les premières ouvertures traversent la couche électriquement conductrice et délimitent des portions de la couche électriquement conductrice formant une partie de chacune des deuxièmes électrodes.

Le procédé peut comporter en outre, entre la réalisation des premières portions électriquement conductrices et la suppression du substrat, la mise en œuvre d'un report de l'empilement et du substrat sur un support tel que l'empilement soit disposé entre le substrat et le support. Dans une telle configuration, la face avant de l'empilement est disposée en regard du support.

Le report de l'empilement et du substrat peut être mis en œuvre avec des éléments de connexion électriquement conducteurs reliant électriquement les premières et deuxièmes électrodes des diodes au support lors de la mise en œuvre du report de l'empilement et du substrat sur le support.

L'étape de suppression du substrat peut être mise œuvre collectivement pour plusieurs dispositifs à diodes photo-émettrices et/ou photo-réceptrices comprenant chacun un empilement et un substrat reportés sur un support, et les supports des dispositifs à diodes photo-émettrices et/ou photo-réceptrices peuvent être solidarisés sur une plaque de maintien avant la mise en œuvre de l'étape de suppression du substrat.

Les premières ouvertures peuvent être réalisées telles qu'elles forment un motif de grille entourant chacune des diodes.

Les étapes de gravure peuvent être mises en œuvre telles que chacune des premières ouvertures délimitant des jonctions p-n de diodes photo-émettrices ait une plus petite dimension, au niveau d'une paroi de fond formée dans le substrat, qui soit inférieure à une plus petite dimension de la première ouverture au niveau d'une interface entre le substrat et l'empilement, et/ou chacune des premières ouvertures délimitant des jonctions p-n de diodes photo-réceptrices ait une plus petite dimension, au niveau de la paroi de fond formée dans le substrat, qui soit supérieure à la plus petite dimension de la première ouverture au niveau de l'interface entre le substrat et l'empilement. De telles configuration sont favorables pour améliorer la directivité d'émission des diodes photo-émettrices et réduire le cross-talk entre des diodes photo-réceptrices.

Le procédé peut comporter en outre, après l'étape de suppression du substrat, la mise en œuvre d'une étape de dépôt d'au moins une couche anti-reflet et/ou métallique sur la grille de collimation, et/ou la mise en œuvre d'un traitement augmentant la rugosité de la grille de collimation. De telles étapes peuvent améliorer les qualités optiques de la grille de collimation.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1J représentent les étapes d'un procédé de réalisation d'un dispositif à diodes photo-émettrices et/ou photo-réceptrices selon un mode de réalisation particulier ;
- la figure 2 représente une structure intermédiaire obtenue lors de la mise en œuvre d'un procédé de réalisation d'un dispositif à diodes photo-émettrices et/ou photo-réceptrices selon une variante de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

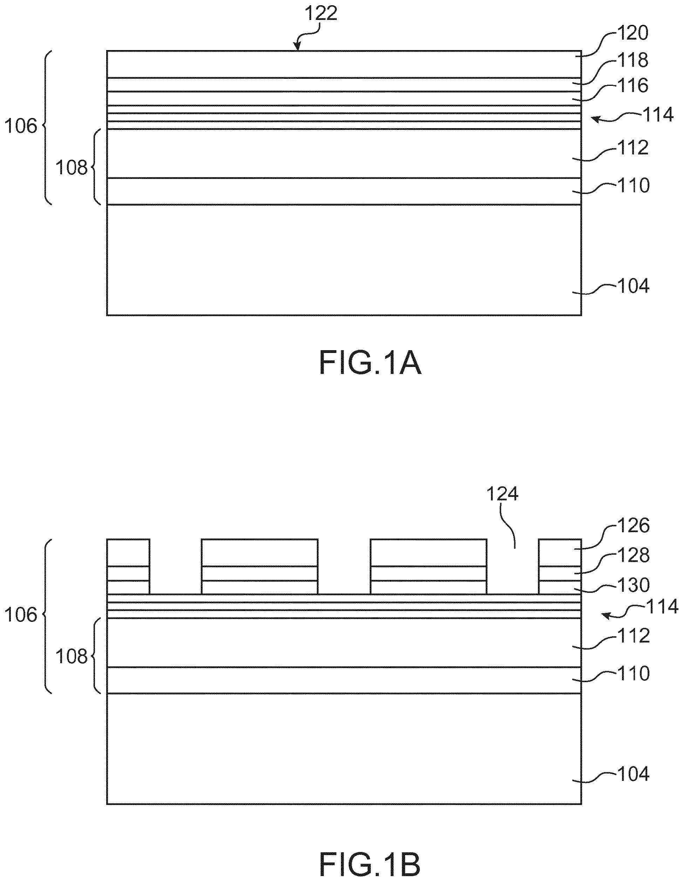

Les figures 1A à 1J représentent les étapes d'un procédé de réalisation d'un dispositif 100 à diodes photo-émettrices et/ou photo-réceptrices selon un mode de réalisation particulier. Dans ce mode de réalisation, le dispositif 100 comporte plusieurs diodes 102 formant au moins une matrice de diodes et servant de matrice(s) de pixels du dispositif 100. En variante, les diodes 102 peuvent être réalisées les unes à côté des autres sans former une matrice de diodes, c'est-à-dire sans espacement régulier entre elles. En outre, dans le mode de réalisation particulier décrit ci-dessous, les diodes 102 correspondent à des diodes photo-émettrices, ici des LEDs.

Comme représenté sur la figure 1A, le dispositif 100 est réalisé à partir d'un substrat 104 comprenant par exemple du saphir et/ou du silicium et/ou un semi-conducteur par exemple similaire à celui utilisé pour former la partie active des diodes 102, et/ou du siliciure de carbone et/ou du verre et/ou tout autre matériau permettant au substrat 104 de former un substrat de croissance permettant la réalisation de l'empilement semi-conducteur formant la partie active des diodes 102. Le substrat 104 sert de support pour le dépôt et/ou la croissance de couches destinées à la réalisation des diodes 102 du dispositif 100.

Un empilement 106 de couches est formé sur le substrat 104. Cet empilement 106 comporte des matériaux à partir desquels les diodes 102 vont être réalisées.

L'empilement 106 comporte une première couche 108 de semi-conducteur dopé selon un premier type de conductivité, par exemple de type n, déposée sur le substrat 104. Dans le mode de réalisation particulier décrit ici, cette première couche 108 correspond à une superposition de plusieurs couches distinctes de semi-conducteur, par exemple une couche 110 de semi-conducteur dopé n+ avec une concentration de donneurs par exemple comprise entre environ 5.10¹⁷ et 5.10²⁰ donneurs/cm³ sur laquelle est disposée une autre couche 112 de semi-conducteur dopé n- avec une concentration de donneurs par exemple comprise entre environ 10¹⁷ et 5.10¹⁹ donneurs/cm³. Par exemple, la couche 110 comporte du GaN et la couche 112 comporte de l'InGaN. L'épaisseur de la couche 110 est par exemple supérieure à environ 100 nm, et ici égale à environ 3 µm, et celle de la couche 112 est par exemple comprise entre environ 5 nm et 500 nm. L'épaisseur totale de la première couche 108, c'est-à-dire la somme des épaisseurs des couches 110 et 112 dans l'exemple décrit ici, est par exemple comprise entre environ 20 nm et 10 µm, et de préférence comprise entre environ 2 µm et 4 µm. La couche 110 forme ici une couche tampon disposée entre la couche 112 et le substrat 104 et sert notamment à filtrer les défauts de croissance de la couche 112 afin que ces défauts ne se retrouvent pas dans la couche 112.

En variante, les couches 110 et 112 peuvent être dopées avec un même niveau de dopage de type n (contrairement au cas décrit ci-dessus où la couche 110 est dopée n+ et la couche 112 est dopée n-).

Selon une autre variante, la première couche 108 peut correspondre à une seule couche de semi-conducteur dopé n, et avec une concentration de donneurs par exemple comprise entre environ 10¹⁷ et 5.10²⁰ donneurs/cm³, comportant par exemple du GaN et dont l'épaisseur est par exemple comprise entre environ 20 nm et 10 µm, et avantageusement comprise entre environ 2 µm et 4 µm.

L'empilement 106 comporte également une ou plusieurs couches émissives 114, par exemple cinq couches émissives 114, destinées à former chacune, dans les diodes 102, un puits quantique. Sur la figure 1A, seules trois couches émissives 114 sont représentées. Les couches émissives 114 comportent par exemple de l'InGaN. Chacune des couches émissives 114 est disposée entre deux couches barrières (non visibles sur les figures 1A - 1J), comprenant par exemple du GaN. Les couches émissives 114 sont disposées sur la première couche 108. Les couches émissives 114 comportent des matériaux semi-conducteurs dits intrinsèques, c'est-à-dire non intentionnellement dopés (de concentration en donneurs résiduels n_{nid} par exemple égale à environ 10¹⁷ donneurs/cm³, ou comprise entre environ 10¹⁵ et 10¹⁸ donneurs/cm³). L'épaisseur de chacune des couches émissives 114 est par exemple égale à environ 3 nm et plus généralement comprise entre environ 0,5 nm et 10 nm, et l'épaisseur de chacune des couches barrières est par exemple comprise entre environ 1 nm et 25 nm.

L'empilement 106 comporte également une deuxième couche 116 de semi-conducteur dopé selon un deuxième type de conductivité, opposé à celui du dopage de la première couche 108 et donc ici de type p, avec une concentration d'accepteurs par exemple comprise entre environ 10¹⁷ et 5.10¹⁹ accepteurs/cm³. La deuxième couche 116 est disposée sur les couches émissives 114. Les première et deuxième couches 108 et 116 (et plus particulièrement les couches 112 et 116 dans l'exemple décrit ici) sont destinées à former les jonctions p-n des diodes 102. Le semi-conducteur de la deuxième couche 116 est par exemple du GaN et son épaisseur est par exemple comprise entre environ 20 nm et 10 µm.

Dans une variante de réalisation, une couche de blocage d'électrons (non visible sur la figure 1A) peut être disposée entre la deuxième couche 116 et les couches émissives 114, cette couche de blocage d'électrons comprenant par exemple de l'AIGaN avec par exemple environ 12% d'aluminium et dopée p avec une concentration d'accepteurs par exemple égale à environ 1.10¹⁷ accepteurs/cm³.

Des matériaux autres que ceux cités ci-dessus peuvent être utilisés pour réaliser les diodes 102.

L'empilement 106 comporte également une couche électriquement conductrice 118 destinée à former, dans chacune des diodes 102, une partie d'une deuxième électrode (correspondant à l'anode dans l'exemple décrit ici) qui sera en contact avec le semi-conducteur de la deuxième couche 116. La couche électriquement conductrice 118 est disposée sur la deuxième couche 116. Le matériau électriquement conducteur utilisé est par exemple optiquement réflecteur, et correspond par exemple à de l'aluminium.

Enfin, l'empilement 106 comporte également une couche 120 destinée à former un masque dur diélectrique, disposée sur la couche électriquement conductrice 118. Le matériau de cette couche 120 est par exemple du SiO₂. a face supérieure de la couche 120 forme ici une face avant 122 de l'empilement 106, cette face avant 122 se trouvant du côté opposé à celui disposé contre le substrat 104.

Une première gravure de l'empilement 106 est mise en œuvre depuis la face avant 122 de l'empilement 106 pour former, dans l'empilement 106, des premières ouvertures 124 qui seront utilisées ensuite pour réaliser des première électrodes (correspondant aux cathodes dans l'exemple décrit ici) des diodes 102 ainsi que la grille de collimation du dispositif 100.

Cette première gravure est tout d'abord réalisée dans la couche 120 pour former un masque diélectrique 126 qui servira de masque de gravure pour la gravure des autres couches de l'empilement 106. Le motif formé par les premières ouvertures 124 dans le masque diélectrique 126 correspond à celui des premières électrodes des diodes 102 et de la grille de collimation. Les premières ouvertures 124 sont également destinées à délimiter des portions des première et deuxième couches 108 et 116 formant les jonctions p-n des diodes 102. Dans l'exemple de réalisation décrit ici, les diodes 102 sont réalisées sous la forme de structures mesa, ou structures en îlots. De plus, dans le mode de réalisation particulier décrit ici, les cathodes des diodes 102 forment une cathode commune à plusieurs diodes 102, ou à toutes les diodes 102, du dispositif 100.

Une gravure de la couche électriquement conductrice 118 est ensuite mise en œuvre selon le motif du masque diélectrique 126. Des portions restantes 128 de la couche 118 sont destinées à former des parties des deuxièmes électrodes des diodes 102.

Une gravure de la deuxième couche 116 est ensuite mise en œuvre selon le motif du masque diélectrique 126, formant des portions 130 de semi-conducteur dopé destinées à faire partie des jonctions p-n des diodes 102 (voir figure 1B). Les couches 116, 118 et 120 sont par exemple gravées par la mise en œuvre d'une gravure ionique réactive par un système de torche à plasma, ou ICP-RIE pour « Inductively Coupled Plasma - Reactive Ion Etching ».

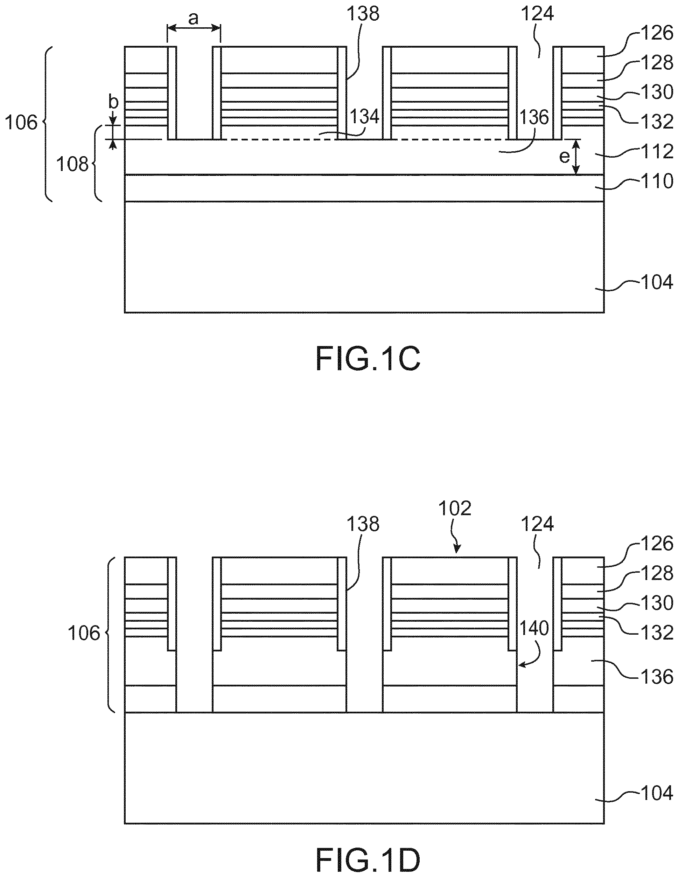

Comme représenté sur la figure 1C, les premières ouvertures 124 sont prolongées par gravure dans les couches émissives 114 et dans une partie de l'épaisseur de la première couche 108, toujours selon le motif défini par le masque diélectrique 126. Cette gravure est stoppée à un niveau de profondeur situé dans la première couche 108 et tel que des parois de fond des premières ouvertures 124 soient formées par la première couche 108. Sur l'exemple décrit ici, la gravure est stoppée à un niveau se situant dans la couche 112 telle que la couche 110 et une partie de l'épaisseur de la couche 112 ne soient pas gravées. L'épaisseur, référencée « b » sur la figure 1C, de la couche 112 qui est gravée est par exemple comprise entre environ 100 nm et 5 µm. L'épaisseur restante de la couche 112 notée « e » résulte donc du choix des épaisseurs initiales des couches 110 et 112 et de la profondeur de la gravure dans la couche 112. Le choix de la profondeur de gravure réalisée, et donc de l'épaisseur restante de la première couche 108 dans le fond des premières ouvertures 124, dépend notamment de l'épaisseur initiale de la première couche 108 (et donc des épaisseurs initiales des couches 110 et 112 dans le mode de réalisation décrit ici) et cela afin que l'épaisseur restante de la première couche 108 soit suffisante pour réaliser un bon contact électrique entre le ou les semi-conducteurs de la première couche 108 et les premières électrodes des diodes 102 qui seront réalisées ultérieurement dans les premières ouvertures 124.

En variante, cette gravure peut être stoppée au niveau de la face supérieure de la couche 110 telle que cette couche 110 ne soit pas gravée mais que toute l'épaisseur de la couche 112 soit gravée. Selon une autre variante, cette gravure peut être stoppée à un niveau se situant dans la couche 110 telle que, dans la première couche 108, seule une partie de l'épaisseur de la couche 110 ne soit pas gravée. Ces deux variantes sont envisageables lorsque le matériau de la couche 110 est adapté pour former, avec le matériau de la couche 116, les jonctions p-n des diodes 102.

Les portions restantes de la ou des couches émissives 114 forment des zones actives 132 des diodes 102. Cette première gravure forme également des parties 134 de portions 136 de semi-conducteur dopé destinées à former, avec les portions 130, les jonctions p-n (jonctions p-i-n dans l'exemple décrit ici, en raison de la présence des couches émissives 114 entre les première et deuxièmes couches 108, 116) des diodes 102 (sur la figure 1C, les parties 134 sont délimitées symboliquement du reste des portions 136 par des traits pointillés).

Une dimension, référencée « a » sur la figure 1C, des premières ouvertures 124 correspondant à la distance entre deux structures mesa de diodes 102 voisines est par exemple supérieure ou égale à environ 50 nm, la distance minimale entre deux diodes 102 voisines étant définie par la résolution minimale de la lithographie mise en œuvre. Cette dimension « a » correspond à la somme de la largeur d'une portion de matériau électriquement conducteur qui sera réalisée entre les deux structures mesa des diodes 102 pour former une cathode commune à ces diodes 102 et des épaisseurs de deux portions diélectriques verticales qui seront également disposées entre les deux structures mesa des diodes 102. Ainsi, la dimension « a » est fonction de la largeur de la cathode réalisée entre les diodes 102 qui est choisie notamment en fonction des pertes acceptables liées à l'amenée du courant électrique dans les zones les plus éloignées des prises de contact périphériques. La gravure mise en œuvre est une gravure sèche, par exemple par un plasma à base de Cl₂ ou une gravure RIE, par exemple ICP-RIE.

Les dimensions des côtés d'une des structures mesa peuvent être comprises entre environ 500 nm et 1 mm, ou entre 500 nm et plusieurs millimètres, selon les applications visées. Pour des applications faisant appel à des diodes de forte puissance (par exemple des ampoules LEDs pour former des phares de voiture), les dimensions des diodes 102 seront plus importantes que pour des applications faisant appel à des diodes 102 de plus faible puissance.

Une couche diélectrique, correspondant par exemple à un bicouche SiN/SiO₂, et formant une couche de passivation, est ensuite déposée avec une épaisseur conforme, par exemple comprise entre environ 5 nm et 1 µm et avantageusement égale à environ 200 nm, sur le masque diélectrique 126 et le long des parois des premières ouvertures 124, recouvrant donc les parois latérales du masque diélectrique 126, des portions 128 électriquement conductrices, des portions 130 de semi-conducteur, des zones actives 132 et des parties 134 des portions 136. La couche diélectrique est également déposée sur les parties non gravées de la première couche 108 formant les parois de fond des premières ouvertures 124. Cette couche diélectrique est par exemple formée par un dépôt de type PECVD (dépôt chimique en phase vapeur assisté par plasma) ou ALD (dépôt de couche atomique) selon la nature du ou des matériaux déposés.

Une gravure anisotrope, par exemple une gravure sèche telle qu'une gravure RIE, est ensuite mise en œuvre telle que les parties de la couche diélectrique se trouvant dans les premières ouvertures 124 et ne recouvrant pas les parois latérales des structures mesa des diodes 102 soient supprimées, révélant ainsi les parties de la première couche 108 se trouvant au fond des premières ouvertures 124. Les parties de cette couche diélectrique recouvrant la face supérieure du masque diélectrique 126 sont également supprimées. Ainsi, seules des portions 138 de la couche diélectrique recouvrant les parois latérales du masque diélectrique 126, des portions électriquement conductrices 128, des portions de semi-conducteur 130, des zones actives 132 et des parties 134 des portions de semi-conducteur 136 sont conservées dans les premières ouvertures 124.

Comme représenté sur la figure 1D, une deuxième gravure de l'empilement 106 est mise en œuvre, prolongeant les premières ouvertures 124 à travers l'épaisseur restante de la première couche 108 de semi-conducteur jusqu'à atteindre le substrat 104, c'est-à-dire jusqu'à ce que les parois de fond des premières ouvertures 124 soient formées par le substrat 104. Cette deuxième gravure permet de délimiter les portions de semi-conducteur 136 entre elles et achève la formation des structures mesa des diodes 102. Cette deuxième gravure permet de révéler des flancs latéraux 140 des portions 136 qui vont former des zones de contact électrique pour les premières électrodes des diodes 102.

A l'issue de cette deuxième gravure, les portions du masque diélectrique 126, les portions électriquement conductrices 128, les portions de semi-conducteur 130 et 136, les zones actives 132 et les portions diélectriques 138 forment des structures mesa, c'est-à-dire des empilements sous forme d'îlots, disposées sur le substrat 104. Chaque structure mesa de chaque diode 102 a une section, dans un plan parallèle à la face du substrat 104 sur laquelle reposent ces structures, par exemple en forme de disque. Chacune des structures mesa peut donc former un îlot de forme cylindrique. Des structures mesa de forme différente sont envisageables, par exemple en forme de pavé.

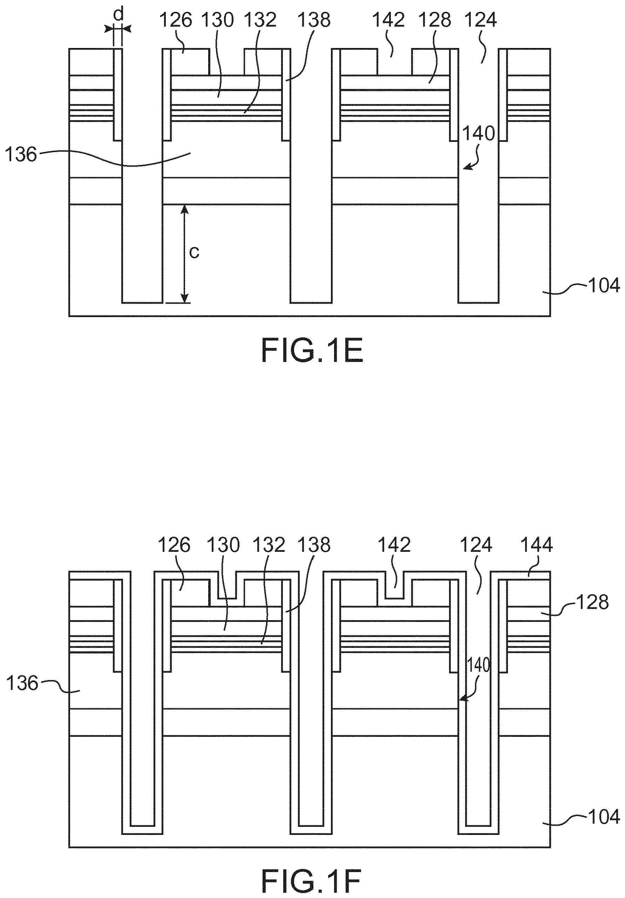

Une autre étape de gravure supplémentaire anisotrope, par exemple de type RIE ou DRIE et sélective vis-à-vis des matériaux des diodes 102 autres que celui ou ceux du substrat 104, est mise en œuvre pour prolonger les premières ouvertures 124 à travers une partie de l'épaisseur du substrat 104, appelée « c » sur la figure 1E.

Des premières portions électriquement conductrices sont destinées à être réalisées dans les premières ouvertures 124 pour former les premières électrodes des diodes 102 ainsi que la grille de collimation du dispositif 100. La profondeur « c » des parties des premières ouvertures 124 dans le substrat 104 correspond à la hauteur de la grille de collimation qui sera obtenue à l'issue du procédé. La valeur de cette profondeur « c » dépend ainsi du type des diodes 102 et des performances de séparation et/ou de focalisation recherchées. Par exemple, lorsque les diodes 102 correspondent à des LEDs, la profondeur « c » est par exemple comprise entre environ 1 µm et 20 µm, et avantageusement supérieure ou égale à environ 10 µm. Par exemple, pour des pixels ayant des côtés de dimension égale à 40 µm, la profondeur « c » est par exemple égale à 10 µm.

En considérant que l'épaisseur de chacune des portions 138 est appelée « d », la largeur, ou plus généralement la dimension latérale, de chacune des premières ouvertures 124 dans le substrat 104 est égale à « a - 2d ». Les dimensions a, c et d sont donc choisies telles que le facteur de forme (hauteur/largeur) des premières ouvertures 124 soit avantageusement supérieur ou égal à 2, voire supérieur ou égal à 4.

Des deuxièmes ouvertures 142 sont ensuite réalisées à travers le masque diélectrique 126, formant des emplacements pour la réalisation des deuxièmes électrodes des diodes 102 (figure 1E). Ces deuxièmes ouvertures 142 traversent toute l'épaisseur du masque diélectrique 126 afin que les parois de fond des deuxièmes ouvertures 142 soient formées par les portions électriquement conductrices 128. Cette gravure est par exemple de type ICP-RIE.

Un premier matériau électriquement conducteur 144 est ensuite déposé dans les premières et deuxièmes ouvertures 124, 142 ainsi que sur le masque diélectrique 126 (figure 1F). Ce premier matériau électriquement conducteur 144 est déposé de manière conforme, c'est-à-dire en formant une couche d'épaisseur sensiblement constante sur le masque diélectrique 126 et le long des parois latérales et les parois de fond des premières et deuxièmes ouvertures 124, 142. Dans l'exemple de réalisation décrit ici, le premier matériau électriquement conducteur 144 est formé par le dépôt, par exemple de type PVD, d'une première couche de titane d'épaisseur par exemple comprise entre environ 5 nm et 300 nm, suivi d'un dépôt, par exemple PVD, d'une deuxième couche d'aluminium d'épaisseur par exemple comprise entre environ 50 nm et 1 µm. Les techniques des dépôts mis en œuvre sont choisies pour qu'elles soient adaptées au facteur de forme important des volumes formés par les premières ouvertures 124, et correspondent par exemple à celles mises en œuvre pour déposer le ou les matériaux électriquement conducteurs des vias conducteurs ou TSV (« Through-Silicon Via »).

Le premier matériau électriquement conducteur 144 est en contact électriquement avec les flancs latéraux 140 des portions de semi-conducteur 136 dans les premières ouvertures 124, et avec les portions 128 au niveau des parois de fond des deuxièmes ouvertures 142.

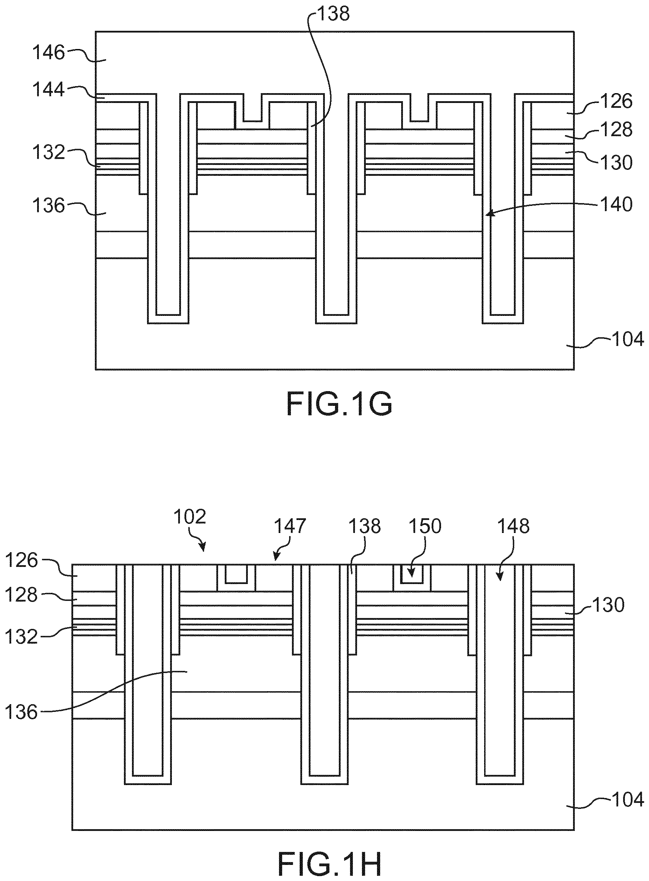

Comme représenté sur la figure 1G, un deuxième matériau électriquement conducteur 146 est déposé en remplissant les volumes restants des premières et deuxièmes ouvertures 124, 142. Sur la figure 1G, l'épaisseur de ce deuxième matériau électriquement conducteur 146 est telle qu'il recouvre également les parties du premier matériau électriquement conducteur 144 disposées sur le masque diélectrique 126. Le deuxième matériau électriquement conducteur 146 est par exemple du cuivre qui peut être formé par la mise en œuvre d'un dépôt électrochimique (ECD ou « Electro-Chemical Deposition ») pleine plaque, c'est-à-dire sur l'ensemble de la structure précédemment réalisée.

Les diodes 102 du futur dispositif 100 sont achevées en mettant en œuvre une planarisation mécano-chimique (CMP) afin de supprimer les portions des premier et deuxième matériaux électriquement conducteurs 144 et 146 qui dépassent des premières et deuxièmes ouvertures 124, 142 (voir figure 1H). Cette planarisation permet d'isoler électriquement les matériaux électriquement conducteurs présents dans les premières ouvertures 124 vis-à-vis des ceux disposés dans les deuxièmes ouvertures 142.

Les matériaux électriquement conducteurs présents dans les premières ouvertures 124 forment des premières portions électriquement conductrices 148 s'étendant sur toute la hauteur des structures mesa des diodes 102, qui sont reliées électriquement aux portions de semi-conducteur 136 uniquement au niveau des flancs latéraux 140, et qui se prolongent dans le substrat 104. Les parties de ces premières portions électriquement conductrices 148 se trouvant au niveau des structures mesa des diodes 102 forment les premières électrodes des diodes 102, et les parties de ces premières portions électriquement conductrices 148 se trouvant dans la couche 108 et dans le substrat 104 sont destinées à former la grille de collimation du futur dispositif 100.

Les matériaux électriquement conducteurs présents dans les deuxièmes ouvertures 142 forment des deuxièmes portions électriquement conductrices 150 correspondant aux deuxièmes électrodes des diodes 102, chacune en contact électriquement avec l'une des portions de semi-conducteur 130 par l'intermédiaire d'une des portions électriquement conductrices 128.

La structure obtenue comporte une face supérieure 147 qui est sensiblement plane, formée par les faces supérieures des premières et deuxièmes portions électriquement conductrices 148, 150, des portions diélectriques 138 et du masque diélectrique 126. Cette face 147 correspond à la face avant des diodes 102 au niveau desquelles des connexions électriques avec les électrodes seront réalisées.

Grâce aux portions diélectriques 138 verticales, les premières portions électriquement conductrices 148 sont bien isolées électriquement des portions de semi-conducteur 130 et des zones actives 132. L'épaisseur « d » des portions diélectriques 138 peut être choisie telle qu'un courant de fuite acceptable soit toléré sur chacune des diodes 102, par exemple inférieur à environ 1 % du courant nominal traversant la diode 102, lorsqu'elles sont soumises à une différence de potentiels (appliquée entre la cathode et l'anode) par exemple de l'ordre de 4 Volts. L'épaisseur minimale des portions diélectriques 138 est par exemple comprise entre environ 3 nm et 5 nm, ou entre 3 nm et 4 nm, en fonction du ou des matériaux utilisés pour réaliser les portions diélectriques 138.

Afin de garantir une isolation électrique entre les premières et deuxièmes électrodes des diodes 102, et éviter la présence des matériaux électriquement conducteurs 144 et 146 sur la face 147 qui pourraient créer un court-circuit entre deux électrodes, l'étape de planarisation est avantageusement mise en œuvre jusqu'à réaliser une sur-gravure des premières et deuxièmes portions électriquement conductrices 148, 150 par rapport aux matériaux diélectriques des portions 138 et du masque diélectrique 126, formant dans les premières et deuxièmes portions électriquement conductrices 148, 150 des creux au niveau des faces supérieures de ces portions. Ces creux peuvent avoir une profondeur, par rapport au plan de la face supérieure 147, comprise entre environ 5 nm et 150 nm. Cette sur-gravure peut être obtenue en jouant sur l'anisotropie de gravure et grâce à la sélectivité de gravure qui existe entre les matériaux diélectriques des portions 138 et du masque 126 et les matériaux des portions électriquement conductrices 148, 150. La CMP mise en œuvre présente une vitesse d'abrasion différente en fonction des matériaux, et dans le procédé décrit ici, l'abrasion des matériaux des portions électriquement conductrices 148, 150 est plus rapide que celle des matériaux diélectriques des portions 138 et du masque 126. Cela se traduit, au niveau de la face supérieure 147, par un retrait des matériaux des portions électriquement conductrices 148, 150 par rapport aux portions diélectriques 138 et au masque diélectrique 126. Ainsi, les électrodes des diodes 102 restent parfaitement isolées les unes des autres grâce à une propriété intrinsèque de la planarisation mise en œuvre. Une telle sur-gravure peut également être mise en œuvre par un procédé de gravure RIE.

Dans le mode de réalisation décrit ci-dessus, les portions de semi-conducteur 136 sont de type n et les portions de semi-conducteur 130 sont de type p. En variante, les portions de semi-conducteur 136 peuvent être de type p et les portions de semi-conducteur 130 peuvent être de type n. Dans cette variante, les premières portions électriquement conductrices 148 forment les anodes des diodes 102 et les deuxièmes portions électriquement conductrices 150 forment, avec les portions conductrices 128, les cathodes des diodes 102.

La surface sensiblement plane obtenue au niveau de la face supérieure 147 permet d'hybrider aisément la matrice de diodes 102 réalisée à tout type de support tel qu'un circuit électronique. Par exemple, il est possible de réaliser une hybridation entre la matrice de diodes 102 et un support correspondant à un circuit électronique par collage direct (« direct bonding », également appelé collage par adhésion moléculaire) de la matrice de diodes 102 au circuit électronique, ou en faisant appel à éléments de connexion électrique entre la matrice de diodes 102 et le circuit électronique. Des détails de mise en œuvre d'un collage direct sont par exemple décrits dans le document « Mechanisms of copper direct bonding observed by in-situ and quantitative transmission electron microscopy » de M. Martinez et al., Thin Solid Films 530 (2013) 96-99.

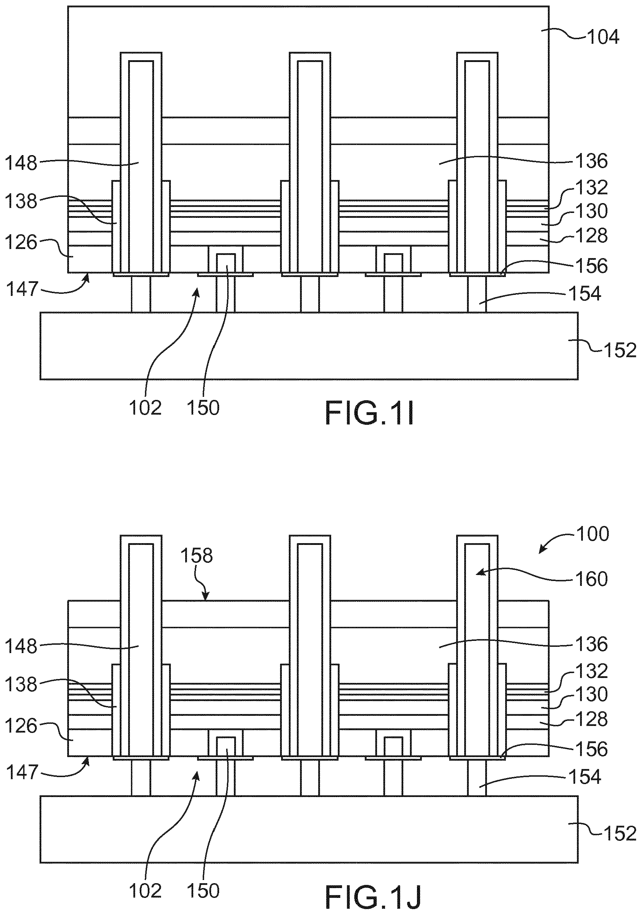

Dans l'exemple non-limitatif de réalisation représenté sur la figure 1I, la matrice de diodes 102 est reportée sur un support 152 comportant des éléments de connexion électrique 154 auxquels les premières et deuxièmes électrodes des diodes 102 sont reliées électriquement. La face 147 de la matrice de diodes 102, correspondant aux faces avant des diodes 102, est disposée en regard du support 152. Les éléments de connexion électrique 154 correspondent par exemple à des billes en alliage fusible (comprenant par exemple du SnAg et/ou de l'indium), ou à des piliers de cuivre recouverts d'un matériau de soudure, ou à des micro-inserts, ou à des micro-tubes.

Ce support 152 peut correspondre à un circuit électronique, comprenant par exemple des composants électroniques CMOS, sur lequel la matrice de diodes 102 est reportée et auquel la matrice de diodes 102 est reliée électriquement. Un tel circuit électronique peut notamment servir à commander électriquement les diodes 102 correspondant par exemple à des diodes électroluminescentes et/ou à traiter les signaux délivrés par les diodes 102 correspondant par exemple à des photodiodes. En variante, le support 152 peut correspondre à un élément passif ne comportant pas de composants électroniques, comme par exemple une carte ou un substrat organique.

Dans l'exemple de réalisation représenté sur la figure 1I, des plots de connexion 156 de type UBM (pour « Under Bump Metallization ») sont réalisés sur la face 147, contre les premières et deuxièmes électrodes des diodes 102, avant le report des diodes sur le support 152. Ces plots de connexion 156 assurent un bon contact électrique entre les premières et deuxièmes électrodes des diodes 102 et les éléments de connexion électrique 154.

Lors du report de la matrice de diodes 102 sur le support 154, la présence du substrat 104 permet d'assurer une rigidité mécanique suffisante pour la manipulation et de la solidarisation de la matrice de diodes 102 au support 154.

Après ce report, le substrat 104 est supprimé, libérant ainsi des faces arrières 158 des diodes par lesquelles la lumière est destinée à entrer ou sortir suivant que les diodes 102 soient des diodes photo-émettrices ou photo-réceptrices. Les techniques de retrait du substrat 104 qui sont mises en œuvre doivent prendre en compte la présence des parties des premières portions électriquement conductrices 148 se trouvant dans le substrat 104 et qui sont destinées à former la grille de collimation. Ainsi, le procédé de retrait mis en œuvre est sélectif par rapport au(x) matériau(x) des premières portions électriquement conductrices 148 présent(s) dans le substrat 104. Par exemple, il est possible de retirer dans un premier temps une partie de l'épaisseur du substrat 104, dans laquelle les premières portions électriquement conductrices 148 ne s'étendent pas, par la mise en œuvre d'un procédé non sélectif, par exemple par rodage, puis de retirer les portions restantes du substrat 104 de manière sélective, par exemple par gravure chimique ou physique. Il est également possible de retirer le substrat 104 par décollement laser (« laser lift-off »). Lorsque le substrat 104 comporte du saphir, ce substrat 104 peut être supprimé par gravure plasma RIE. La ou les techniques mises en œuvre pour supprimer le substrat 104 sont adaptées en fonction du matériau du substrat 104.

La structure obtenue après la suppression du substrat 104 est représentée sur la figure 1J. Les parties des premières portions électriquement conductrices 148 libérées du substrat 104 forment au moins en partie la grille de collimation 160 du dispositif 100.

De manière optionnelle, après avoir supprimé le substrat 104, il est possible de déposer une ou plusieurs couches de matériau(x) sur la grille de collimation 160 et/ou de réaliser un ou plusieurs traitements de surface de la grille de collimation 160. Par exemple, il est possible de mettre en œuvre un traitement visant à améliorer les performances de la grille de collimation 160. Ce traitement peut comporter le dépôt d'un matériau métallique sur la grille de collimation 160, améliorant les qualités optiques de la grille de collimation 160 comme par exemple les propriétés antireflets de la grille de collimation 160. Ce traitement (par exemple une gravure) peut également augmenter la rugosité de la grille de collimation 160. Ce traitement peut être sélectif ou non vis-à-vis des faces arrières 158 des diodes 102.

Dans le mode de réalisation particulier décrit ci-dessus, le dispositif 100 comporte avantageusement une matrice de diodes 102 qui sont des diodes électroluminescentes, le dispositif microélectronique pouvant faire partie d'un dispositif d'affichage à LEDs (écrans, projecteur, mur d'images, etc.). Cette matrice de diodes 102 comporte les premières portions électriquement conductrices 148 qui forment une cathode commune à toutes les diodes 102, et chaque diode 102 comporte une deuxième portion électriquement conductrice 150 formant une anode permettant de réaliser l'adressage individuel de chacune des diodes 102.

En variante, le dispositif microélectronique 100 peut comporter une matrice de diodes 102 qui sont des diodes photo-réceptrices, ou photodiodes. Dans cette variante, les anodes et les cathodes des diodes 102 ne servent pas à fournir du courant aux diodes 102 mais servent à récupérer les courants photo-générés par les diodes 102.

Selon une autre variante, que les diodes 102 correspondent à des diodes électroluminescentes ou à des photodiodes, les structures mesa des diodes 102 peuvent ne pas comporter de couches entre les portions de semi-conducteur dopées 130 et 136 (correspondant aux zones actives émissives ou à des portions de semi-conducteur intrinsèque), et les semi-conducteurs dopés p et n sont alors disposés directement l'un contre l'autre.

Dans le mode de réalisation particulier précédemment décrit, les premières portions électriquement conductrices 148 sont réalisées telles que les parties formant la grille de collimation 160 comportent des flancs latéraux sensiblement perpendiculaires aux faces arrières 158 des diodes 102. En variante, il est possible que les angles formés entre ces flancs latéraux et les faces arrières 158 des diodes 102 ne soient pas égaux à 90°.

Par exemple, lorsque les diodes 102 correspondent à des diodes photo-émettrices, les premières ouvertures 124 peuvent être réalisées telles que leur largeur, au niveau de leurs parois de fond localisées dans le substrat 104, soit inférieure à leur largeur au niveau d'une interface entre le substrat 104 et l'empilement de couches formant les jonctions p-n des diodes 102. Ce profil des premières ouvertures 124 se retrouve donc sur les parties des premières portions électriquement conductrices 148 formant la grille de collimation 160. Ce profil particulier de la grille de collimation 160 est avantageux lorsque les diodes 102 correspondent à des diodes électroluminescentes car une telle grille de collimation permet de réduire les réflexions parasites de la lumière émise par les diodes 102.

Lorsque les diodes 102 correspondent à des diodes photo-réceptrices, la grille de collimation 160 peut être réalisée avec un profil inverse à celui décrit ci-dessus, c'est-à-dire tel que la largeur des premières portions électriquement conductrices 148, au niveau des parois de fond localisées dans le substrat 104, soit supérieure à leur largeur au niveau de l'interface entre le substrat 104 et l'empilement de couches formant les jonctions p-n des diodes 102. Ce profil particulier de la grille de collimation 160 est avantageux lorsque les diodes 102 correspondent à des photodiodes car une telle grille de collimation 160 permet de réduire l'effet de cross-talk entre les diodes 102.

Selon une variante de réalisation, après avoir supprimé le substrat 104, il est possible de graver partiellement la couche 110, sur une partie de son épaisseur, afin d'augmenter la hauteur des parties des premières portions électriquement conductrices 148 formant la grille de collimation 160.

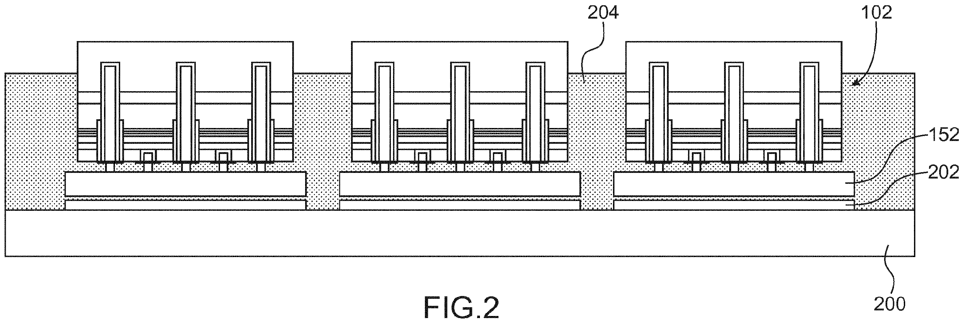

Selon une variante de réalisation, l'étape de suppression du substrat 104 et éventuellement de la gravure partielle de la couche 110 peut être mise en œuvre collectivement pour plusieurs dispositifs 100. Comme représenté sur la figure 2, plusieurs futurs dispositifs 100 comprenant chacun les diodes 102 reportées sur le support 152 mais comprenant encore le substrat 104 sont reportés sur une plaque de maintien 200, et sont par exemple maintenus à cette plaque par l'intermédiaire d'une couche de colle temporaire 202. Sur l'exemple représenté sur la figure 2, les futurs dispositifs 100 sont protégés par un matériau encapsulant 204, comprenant par exemple un polymère, formé autour des dispositifs 100 mais ne recouvrant pas les substrats 104 des futurs dispositifs 100 afin que ces substrats 104 soient accessibles. Les substrats 104 des futurs dispositifs 100 peuvent ensuite être retirés en mettant en œuvre les techniques précédemment décrites, et cela sans risque d'endommager les diodes 102 grâce à la présence du matériau encapsulant 204. Après avoir retiré les substrats 104, le matériau encapsulant 204 est retiré, par exemple par dissolution, et les dispositifs 100 sont décollés de la plaque de maintien 200. En variante, une étape de traitement des grilles de collimation 160 des dispositifs 100 peut être mise en œuvre collectivement avant de retirer le matériau encapsulant 204.

Les revendications qui suivent définissent l'objet de la protection conférée par la présente invention.

## Revendications

1. Procédé de réalisation d'au moins un dispositif (100) à diodes (102) photo-émettrices et/ou photo-réceptrices, comportant au moins :
- réalisation, sur un substrat (104), d'un empilement (106) de couches comprenant au moins des première et deuxième couches (108, 116) de semi-conducteurs dopés selon des types de conductivité opposés, la première couche (108) étant disposée entre le substrat (104) et la deuxième couche (116) ;
- première gravure de l'empilement (106) depuis une face avant (122) de l'empilement (106) se trouvant du côté opposé à celui disposé contre le substrat (104), formant des premières ouvertures (124) traversant toute l'épaisseur de la deuxième couche (116) et dont des parois de fond sont formées par la première couche (108) ;
- réalisation de portions diélectriques (138) recouvrant, dans les premières ouvertures (124), des flancs latéraux formés au moins par la deuxième couche (116) ;
- deuxième gravure de l'empilement (106), prolongeant les premières ouvertures (124) à travers une épaisseur restante de la première couche (108) jusqu'à atteindre le substrat (104), les premières ouvertures (124) délimitant des portions (130, 136) des première et deuxième couches (108, 116) formant des jonctions p-n des diodes (102) ;
- gravure supplémentaire prolongeant les premières ouvertures (124) dans une partie du substrat (104) ;
- réalisation de premières portions électriquement conductrices (148) disposées dans les premières ouvertures (124) et en contact électriquement avec des flancs latéraux (140) des portions (136) de la première couche (108), formant des premières électrodes des diodes (102), et réalisation de deuxièmes électrodes (150) reliées électriquement aux portions (130) de la deuxième couche (116) ;
- suppression du substrat (104), révélant une face arrière (158) de chacune des diodes (102) et libérant des parties des premières portions électriquement conductrices (148) formant une grille de collimation (160).

2. Procédé selon la revendication 1, dans lequel la partie du substrat (104) dans laquelle la gravure supplémentaire prolongeant les premières ouvertures (124) est mise en œuvre a une épaisseur comprise entre 1 µm et 20 µm et/ou dans lequel un rapport entre l'épaisseur de la partie du substrat (104) dans laquelle la gravure supplémentaire prolongeant les premières ouvertures (124) est mise en œuvre et une plus petite dimension de chaque première ouverture (124) dans un plan parallèle à une interface entre le substrat (104) et l'empilement (106) est supérieur ou égal à 2.

3. Procédé selon l'une des revendications précédentes, dans lequel :
- la première gravure de l'empilement (106) est mise en œuvre telle que les premières ouvertures (124) traversent également une partie (134) de la première couche (108), et
- les portions diélectriques (138) sont réalisées telles qu'elles recouvrent, dans les premières ouvertures (124), des flancs latéraux de ladite partie (134) de la première couche (108).

4. Procédé selon l'une des revendications précédentes, dans lequel :
- l'empilement (106) comporte un masque diélectrique (126) formant la face avant (122) de l'empilement (106),
- les première et deuxième gravures de l'empilement (106) sont mises en œuvre à travers le masque diélectrique (126) telles que les premières ouvertures (124) traversent également le masque diélectrique (126), et
- les portions diélectriques (138) recouvrent également, dans les premières ouvertures (124), des flancs latéraux du masque diélectrique (126).

5. Procédé selon la revendication 4, dans lequel la deuxième gravure de l'empilement (106) est réalisée telle que des flancs latéraux des portions diélectriques (138) sont alignés avec les flancs latéraux (140) des portions (136) de la première couche (108).

6. Procédé selon l'une des revendications 4 ou 5, comportant en outre, entre la deuxième gravure de l'empilement (106) et la réalisation des premières portions électriquement conductrices (148), la réalisation de deuxièmes ouvertures (142) traversant le masque diélectrique (126) et dans lesquelles les deuxièmes électrodes (150) sont au moins partiellement réalisées.

7. Procédé selon la revendication 6, dans lequel les premières et deuxièmes électrodes sont réalisées en déposant au moins un matériau électriquement conducteur (144, 146) dans les premières et deuxièmes ouvertures (124, 142) et sur le masque diélectrique (126), puis en mettant en œuvre une étape de planarisation du matériau électriquement conducteur (144, 146) avec arrêt sur le masque diélectrique (126).

8. Procédé selon l'une des revendications précédentes, dans lequel l'empilement (106) comporte en outre une couche électriquement conductrice (118) telle que la deuxième couche (116) soit disposée entre la couche électriquement conductrice (118) et la première couche (108), et dans lequel la première gravure de l'empilement (106) est mise en œuvre telle que les premières ouvertures (124) traversent la couche électriquement conductrice (118) et délimitent des portions (128) de la couche électriquement conductrice (118) formant une partie de chacune des deuxièmes électrodes (150).

9. Procédé selon l'une des revendications précédentes, comportant en outre, entre la réalisation des premières portions électriquement conductrices (148) et la suppression du substrat (104), la mise en œuvre d'un report de l'empilement (106) et du substrat (104) sur un support (152) tel que l'empilement (106) soit disposé entre le substrat (104) et le support (152).

10. Procédé selon la revendication 9, dans lequel le report de l'empilement (106) et du substrat (104) est mis en œuvre avec des éléments de connexion électriquement conducteurs (154) reliant électriquement les premières et deuxièmes électrodes des diodes (102) au support (152) lors de la mise en œuvre du report de l'empilement (106) et du substrat (104) sur le support (152).

11. Procédé selon l'une des revendications 9 ou 10, dans lequel l'étape de suppression du substrat (104) est mise en œuvre collectivement pour plusieurs dispositifs (100) à diodes (102) photo-émettrices et/ou photo-réceptrices comprenant chacun un empilement (106) et un substrat (104) reportés sur un support (152), et dans lequel les supports (152) des dispositifs (100) à diodes (102) photo-émettrices et/ou photo-réceptrices sont solidarisés sur une plaque de maintien (200) avant la mise en œuvre de l'étape de suppression du substrat (104).

12. Procédé selon l'une des revendications précédentes, dans lequel les premières ouvertures (124) sont réalisées telles qu'elles forment un motif de grille entourant chacune des diodes (102).

13. Procédé selon l'une des revendications précédentes, dans lequel les étapes de gravure sont mises en œuvre telles que :
- chacune des premières ouvertures (124) délimitant des jonctions p-n de diodes (102) photo-émettrices ait une plus petite dimension, au niveau d'une paroi de fond formée dans le substrat (104), qui soit inférieure à une plus petite dimension de la première ouverture (124) au niveau d'une interface entre le substrat (104) et l'empilement (106), et/ou
- chacune des premières ouvertures (124) délimitant des jonctions p-n de diodes (102) photo-réceptrices ait une plus petite dimension, au niveau de la paroi de fond formée dans le substrat (104), qui soit supérieure à la plus petite dimension de la première ouverture (124) au niveau de l'interface entre le substrat (104) et l'empilement (106).

14. Procédé selon l'une des revendications précédentes, comportant en outre, après l'étape de suppression du substrat (104), la mise en œuvre d'une étape de dépôt d'au moins une couche anti-reflet et/ou métallique sur la grille de collimation (160), et/ou la mise en œuvre d'un traitement augmentant la rugosité de la grille de collimation (160).

## Patentansprüche

1. Verfahren zum Herstellen zumindest einer Vorrichtung (100) mit lichtemittierenden und/oder lichtempfangenden Dioden (102), zumindest umfassend:
- Bilden eines Stapels (106) von Schichten auf einem Substrat (104), der zumindest eine erste und eine zweite Schicht (108, 116) von Halbleitern enthält, die gemäß entgegengesetzten Leitfähigkeitstypen dotiert sind, wobei die erste Schicht (108) zwischen dem Substrat (104) und der zweiten Schicht (116) angeordnet ist;
- erstes Ätzen des Stapels (106) ausgehend von einer vorderen Fläche (122) des Stapels (106), die sich auf der entgegengesetzten Seite zu derjenigen befindet, die am Substrat (104) angeordnet ist, wobei erste Öffnungen (124) gebildet werden, die durch die gesamte Dicke der zweiten Schicht (116) hindurchgehen und deren Bodenwände von der ersten Schicht (108) gebildet werden;
- Bilden von dielektrischen Abschnitten (138), die in den ersten Öffnungen (124) seitliche Flanken abdecken, die zumindest von der zweiten Schicht (116) gebildet werden;
- zweites Ätzen des Stapels (106), wodurch die ersten Öffnungen (124) durch eine verbleibende Dicke der ersten Schicht (108) hindurch bis zum Erreichen des Substrats (104) fortgesetzt werden, wobei die ersten Öffnungen (124) Abschnitte (130, 136) der ersten und der zweiten Schicht (108, 116) begrenzen, die p-n-Übergänge der Dioden (102) bilden;
- weiteres Ätzen, wodurch die ersten Öffnungen (124) in einem Teil des Substrats (104) fortgesetzt werden;
- Bilden von ersten elektrisch leitenden Abschnitten (148), die in den ersten Öffnungen (124) angeordnet sind und in elektrischem Kontakt mit seitlichen Flanken (140) der Abschnitte (136) der ersten Schicht (108) stehen und erste Elektroden der Dioden (102) bilden, und Bilden von zweiten Elektroden (150), die mit den Abschnitten (130) der zweiten Schicht (116) elektrisch verbunden sind;
- Entfernen des Substrats (104), wodurch eine hintere Fläche (158) jeder der Dioden (102) freigelegt wird und Teile der ersten elektrisch leitenden Abschnitte (148) freigegeben werden, die ein Kollimationsgitter (160) bilden.

2. Verfahren nach Anspruch 1, wobei der Teil des Substrats (104), in dem das die ersten Öffnungen (124) fortgesetzende weitere Ätzen erfolgt, eine Dicke zwischen 1 µm und 20 µm aufweist und/oder wobei ein Verhältnis zwischen der Dicke des Teils des Substrats (104), in dem das die ersten Öffnungen (124) fortgesetzende weitere Ätzen erfolgt, und einer kleinsten Abmessung jeder ersten Öffnung (124) in einer Ebene parallel zu einer Grenzfläche zwischen dem Substrat (104) und dem Stapel (106) größer oder gleich 2 ist.

3. Verfahren nach einem der vorhergehenden Ansprüche, wobei:
- das erste Ätzen des Stapels (106) so erfolgt, dass die ersten Öffnungen (124) auch durch einen Teil (134) der ersten Schicht (108) hindurchgehen, und
- die dielektrischen Abschnitte (138) so ausgebildet werden, dass sie in den ersten Öffnungen (124) seitliche Flanken des Teils (134) der ersten Schicht (108) abdecken.

4. Verfahren nach einem der vorhergehenden Ansprüche, wobei:
- der Stapel (106) eine dielektrische Maske (126) enthält, die die vordere Fläche (122) des Stapels (106) bildet,
- das erste und das zweite Ätzen des Stapels (106) durch die dielektrische Maske (126) hindurch erfolgt, so dass die ersten Öffnungen (124) auch durch die dielektrische Maske (126) hindurchgehen, und
- die dielektrischen Abschnitte (138) in den ersten Öffnungen (124) auch die seitlichen Flanken der dielektrischen Maske (126) abdecken.

5. Verfahren nach Anspruch 4, wobei das zweite Ätzen des Stapels (106) so erfolgt, dass die seitlichen Flanken der dielektrischen Abschnitte (138) mit den seitlichen Flanken (140) der Abschnitte (136) der ersten Schicht (108) ausgerichtet werden.

6. Verfahren nach einem der Ansprüche 4 oder 5, ferner umfassend zwischen dem zweiten Ätzen des Stapels (106) und des Bildens der ersten elektrisch leitfähigen Abschnitte (148) das Ausbilden von zweiten Öffnungen (142), die durch die dielektrische Maske (126) hindurchgehen und in denen die zweiten Elektroden (150) zumindest teilweise ausgebildet werden.

7. Verfahren nach Anspruch 6, wobei die erste und die zweite Elektrode durch Abscheiden zumindest eines elektrisch leitfähigen Materials (144, 146) in den ersten und zweiten Öffnungen (124, 142) und auf der dielektrischen Maske (126) und anschließendes Ausführen von einem Schritt des Planarisierens des elektrisch leitfähigen Materials (144, 146) mit Aussetzen an der dielektrischen Maske (126) hergestellt werden.

8. Verfahren nach einem der vorhergehenden Ansprüche, wobei der Stapel (106) ferner eine elektrisch leitende Schicht (118) enthält, so dass die zweite Schicht (116) zwischen der elektrisch leitenden Schicht (118) und der ersten Schicht (108) angeordnet ist, und wobei das erste Ätzen des Stapels (106) so erfolgt, dass die ersten Öffnungen (124) durch die elektrisch leitende Schicht (118) hindurchgehen und Abschnitte (128) der elektrisch leitenden Schicht (118) begrenzen, die einen Teil jeder der zweiten Elektroden (150) bilden.

9. Verfahren nach einem der vorhergehenden Ansprüche, wobei zwischen dem Bilden der ersten elektrisch leitenden Abschnitte (148) und dem Entfernen des Substrats (104) ein Übertragen des Stapels (106) und des Substrats (104) auf einen Träger (152) erfolgt, so dass der Stapel (106) zwischen dem Substrat (104) und dem Träger (152) angeordnet wird.

10. Verfahren nach Anspruch 9, wobei das Übertragen des Stapels (106) und des Substrats (104) mit elektrisch leitenden Verbindungselementen (154) erfolgt, die beim Übertragen des Stapels (106) und des Substrats (104) auf den Träger (152) die ersten und die zweiten Elektroden der Dioden (102) mit dem Träger (152) elektrisch verbinden.

11. Verfahren nach einem der Ansprüche 9 oder 10, wobei der Schritt des Entfernens des Substrats (104) für mehrere Vorrichtungen (100) mit lichtemittierenden und/oder lichtempfangenden Dioden (102), die jeweils einen Stapel (106) und ein Substrat (104), die auf einen Träger (152) übertragen sind, enthalten, gemeinsam ausgeführt wird, und wobei die Träger (152) der Vorrichtungen (100) mit lichtemittierenden und/oder lichtempfangenden Dioden (102) an eine Halteplatte (200) befestigt werden, bevor der Schritt des Entfernens des Substrats (104) erfolgt.

12. Verfahren nach einem der vorhergehenden Ansprüche, wobei die ersten Öffnungen (124) so ausgeführt sind, dass sie ein Gittermuster bilden, das jede der Dioden (102) umgibt.

13. Verfahren nach einem der vorhergehenden Ansprüche, wobei die Schritte des Ätzens so durchgeführt werden, dass:
- jede der ersten Öffnungen (124), die p-n-Übergänge von lichtemittierenden Dioden (102) begrenzen, eine kleinste Abmessung an einer in dem Substrat (104) ausgebildeten Bodenwand hat, die kleiner ist als eine kleinste Abmessung der ersten Öffnung (124) an einer Grenzfläche zwischen dem Substrat (104) und dem Stapel (106), und/oder
- jede der ersten Öffnungen (124), die p-n-Übergänge von lichtempfangenden Dioden (102) begrenzen, eine kleinste Abmessung an der im Substrat (104) ausgebildeten Bodenwand hat, die größer ist als die kleinste Abmessung der ersten Öffnung (124) an der Grenzfläche zwischen dem Substrat (104) und dem Stapel (106).

14. Verfahren nach einem der vorhergehenden Ansprüche, ferner umfassend, nach dem Schritt des Entfernens des Substrats (104), das Ausführen eines Schritts des Abscheidens zumindest einer Antireflexions- und/oder Metallschicht auf dem Kollimationsgitter (160), und/oder das Durchführen einer Behandlung, mit der die Rauigkeit des Kollimationsgitters (160) erhöht wird.

## Claims

1. Method for producing at least one device (100) with light emitting and/or light receiving diodes (102), comprising at least:
- producing, on a substrate (104), a stack (106) of layers including at least first and second semiconductor layers (108, 116) doped according to opposite types of conductivity, the first layer (108) being arranged between the substrate (104) and the second layer (116);
- first etching of the stack (106) from a front face (122) of the stack (106) located on the side opposite to that arranged against the substrate (104), forming first openings (124) made through the entire thickness of the second layer (116) and of which the bottom walls are formed by the first layer (108);
- producing dielectric portions (138) covering, in the first openings (124), side walls formed at least by the second layer (116);
- second etching of the stack (106), extending the first openings (124) through a remaining thickness of the first layer (108) until reaching the substrate (104), the first openings (124) delimiting portions (130, 136) of the first and second layers (108, 116) forming the p-n junctions of the diodes (102);
- additional etching extending the first openings (124) into a part of the substrate (104);
- producing first electrically conductive portions (148) arranged in the first openings (124) and in contact electrically with the side walls (140) of the portions (136) of the first layer (108), forming first electrodes of the diodes (102), and producing second electrodes (150) electrically connected to the portions (130) of the second layer (116);
- eliminating the substrate (104), exposing a rear face (158) of each of the diodes (102) and freeing parts of the first electrically conductive portions (148) forming a collimation grid (160).

2. Method according to claim 1, in which the part of the substrate (104) in which the additional etching extending the first openings (124) is implemented has a thickness between 1 µm and 20 µm and/or in which a ratio between the thickness of the part of the substrate (104) in which the additional etching extending the first openings (124) is implemented and a smallest dimension of each first opening (124) in a plane parallel to an interface between the substrate (104) and the stack (106) is greater than or equal to 2.

3. Method according to one of the preceding claims, in which:
- the first etching of the stack (106) is implemented such that the first openings (124) are also made through a part (134) of the first layer (108), and
- the dielectric portions (138) are produced such that they cover, in the first openings (124), the side walls of said part (134) of the first layer (108).

4. Method according to one of the preceding claims, in which:
- the stack (106) comprises a dielectric mask (126) forming the front face (122) of the stack (106),
- the first and second etchings of the stack (106) are implemented through the dielectric mask (126) such that the first openings (124) are also made through the dielectric mask (126), and
- the dielectric portions (138) also cover, in the first openings (124), the side walls of the dielectric mask (126).

5. Method according to claim 4, in which the second etching of the stack (106) is carried out such that the side walls of the dielectric portions (138) are aligned with the side walls (140) of the portions (136) of the first layer (108).

6. Method according to one of claims 4 or 5, further comprising, between the second etching of the stack (106) and the production of the first electrically conductive portions (148), the production of second openings (142) through the dielectric mask (126) and in which the second electrodes (150) are at least partially produced.

7. Method according to claim 6, in which the first and second electrodes are produced by depositing at least one electrically conductive material (144, 146) in the first and second openings (124, 142) and on the dielectric mask (126), then by implementing a step of planarization of the electrically conductive material (144, 146) with stoppage on the dielectric mask (126).

8. Method according to one of the preceding claims, in which the stack (106) further comprises an electrically conductive layer (118) such that the second layer (116) is arranged between the electrically conductive layer (118) and the first layer (108), and in which the first etching of the stack (106) is implemented such that the first openings (124) are made through the electrically conductive layer (118) and delimit portions (128) of the electrically conductive layer (118) forming a part of each of the second electrodes (150).

9. Method according to one of the preceding claims, further comprising, between the production of the first electrically conductive portions (148) and the elimination of the substrate (104), the implementation of a transfer of the stack (106) and the substrate (104) onto a support (152) such that the stack (106) is arranged between the substrate (104) and the support (152).

10. Method according to claim 9, in which the transfer of the stack (106) and the substrate (104) is implemented with electrically conducive connection elements (154) electrically connecting the first and second electrodes of the diodes (102) to the support (152) during the implementation of the transfer of the stack (106) and the substrate (104) onto the support (152).

11. Method according to one of claims 9 or 10, in which the step of eliminating the substrate (104) is implemented collectively for several devices (100) with light emitting and/or light receiving diodes (102) each including a stack (106) and a substrate (104) transferred onto a support (152), and in which the supports (152) of the devices (100) with light emitting and/or light receiving diodes (102) are made integral on a maintaining wafer (200) before the implementation of the step of eliminating the substrate (104).

12. Method according to one of the preceding claims, in which the first openings (124) are produced such that they form a grid pattern surrounding each of the diodes (102).

13. Method according to one of the preceding claims, in which the etching steps are implemented such that:
- each of the first openings (124) delimiting the p-n junctions of light emitting diodes (102) has a smallest dimension, at the level of a bottom wall formed in the substrate (104), which is less than a smallest dimension of the first opening (124) at the level of an interface between the substrate (104) and the stack (106), and/or
- each of the first openings (124) delimiting the p-n junctions of light receiving diodes (102) has a smallest dimension, at the level of the bottom wall formed in the substrate (104), which is greater than the smallest dimension of the first opening (124) at the level of the interface between the substrate (104) and the stack (106).

14. Method according to one of the preceding claims, further comprising, after the step of elimination of the substrate (104), the implementation of a step of depositing at least one anti-reflective and/or metal layer on the collimation grid (160), and/or the implementation of a treatment increasing the roughness of the collimation grid (160).
